# EUROPEAN PATENT APPLICATION

(11) **EP 2 362 722 A1**
(43) Date of publication of application: **31.08.2011**
(21) Application number: 10290093.3
(22) Date of filing: 25.02.2010
(51) Int. Cl.: H05K 7/20

(54) **Thermally conductive and damping apparatus**

(71) Applicant: Services Pétroliers Schlumberger, 75007 Paris (FR); Schlumberger Technology B.V., 2514 JG The Hague (NL); Schlumberger Holdings Limited, Tortola (VG); PRAD Research and Development Limited, Road Town, Tortola (VG)
(72) Inventor: Delgado, Miguel, 38120 Saint Egreve (FR)
(74) Representative: Vandermolen, Mathieu

(57) **Abstract**

A thermally conductive and damping system, comprising: a highly resistant composite thermally conductive and elastic structure (knitted metal, metallic foam, etc) assembled (by fasteners and/or adhesive and/or solder) between electronic devices which the temperature must be limited or cooled and an external chassis and/or a heat spreader or a cooling system which is subject to shock and/or vibration.

A method of a providing a thermal path between two different physical parts of a system while uncoupling mechanically these two parts, comprising a conductive elastic metallic hollow structure such as a metal mesh, metal foam or a metal fabric with sufficient mechanical strength to not be degraded by the inertia of the protected electric device. The apparatus may act as a thermo conductive viscoelastic suspension and is highly resistant to extreme environment such as high temperature, aggressive gas or vacuum.

## Description

### BACKGROUND

### 1. Technical Field

This present disclosure relates generally to the field of high temperature electronics, and relates more particularly, but not by way of limitation, to thermally conductive and damping apparatus for electronic devices in difficult environmental conditions. These environments may be down hole amongst other places.

### 2. Background Art

As is well known, in high shock and vibration hard environments (such as in launch vehicles, automotive vehicles, airplane, military system and oil drilling environment) electronic devices are generally protected from destructive movement by elastomers in order to filter and damp the kinetic energy. However those elastomers are limited in terms of environment life time survival because they are mechanically weakened and degraded by high temperature and chemical combination with gas and other molecules.

Moreover elastomers even highly filled with thermally conductive particles are poor thermal conductor and efficient thermal drain. This is often not efficient enough to drain heat from high power electronic devices to any distant cooling apparatus. Therefore complex and expensive devices are known to be applied to transport heat form one point to another.

Heretofore, there have been various U.S. design patents and utility patents that describe devices and methods for transporting heat from one point to another. For example, U.S. US 7643309B1 teaches a ruggedized electronics sub-system;
US 6134892A teaches a cooled electrical system for use downhole;
US 5931000A teaches a cooled electrical system for use downhole;
US 7641984B2 teaches a composite metal foam and methods of preparation; and US 25662262A teaches a packing system.

It is therefore desirable to provide a method and apparatus (e.g., which also can be referred to herein as a "system") that addresses the above and other problems.

### SUMMARY OF THE DISCLOSURE

In view of the foregoing disadvantages inherent in the known types of methods and apparatus present in the prior art, exemplary implementations of the present disclosure are directed to a thermally conductive and damping system for electronic devices, particularly but not solely in difficult environmental conditions. Exemplary apparatus, methods and systems thus provide a new and useful thermally conductive and damping apparatus for electronic devices which avoids many of the defects and disadvantages of the prior art mentioned heretofore, and includes many novel features which are not anticipated, rendered obvious, suggested, or even implied by any of the prior art devices or methods, either alone or in any combination thereof.

According to an aspect of the present disclosure, one or more embodiments relate to a thermally conductive and damping system, comprising: a highly resistant composite thermally conductive and elastic structure (knitted metal, metallic foam, etc) assembled (by fasteners and/or adhesive and/or solder) between electronic devices which the temperature must be limited or cooled and an external chassis and/or a heat spreader or a cooling system which is subject to shock and/or vibration.

According to another aspect of the present disclosure, one or more embodiments relate to a providing a thermal path between two different physical parts of a system while uncoupling mechanically these two parts, comprising a conductive elastic metallic hollow structure such as a metal mesh, metal foam or a metal fabric with sufficient mechanical strength to not be degraded by the inertia of the protected electric device. The apparatus may act as a thermo conductive viscoelastic suspension and is highly resistant to extreme environment such as high temperature, aggressive gas or vacuum.

Further, in other aspects of the present disclosure, one or more embodiments relate to a thermally conductive and damping system comprising: a metallic matrix is similar to a spring in the apparatus. It could be made of any metallic material such as steel, light alloy, copper alloy or super alloy. Some hollow structure such as metal fabric or some material internal dislocation induces friction damping which is a part of certain aspects of this disclosure. In other aspects of this disclosure other suitable thermal conductive material may be used in place of the metallic material.

These together with other aspects, features, and advantages of the present disclosure, along with the various features of novelty, which characterize the invention, are pointed out with particularity in the claims annexed to and forming a part of this disclosure. The above aspects and advantages are neither exhaustive nor individually or jointly critical to the spirit or practice of the disclosure. Other aspects, features, and advantages of the present disclosure will become readily apparent to those skilled in the art from the following detailed description in combination with the accompanying drawings. Accordingly, the drawings and description are to be regarded as illustrative in nature, and not restrictive.

### BRIEF DESCRIPTION OF THE DRAWINGS

To assist those of ordinary skill in the relevant art in making and using the subject matter hereof, reference is made to the appended drawings, which are not intended to be drawn to scale, and in which like reference numerals are intended to refer to similar elements for consistency. For purposes of clarity, not every component may be labeled in every drawing.
FIG. 1 depicts an overview a thermally conductive and damping apparatus for electronic devices in accordance with an exemplary embodiment disclosed herein;
FIG. 2 depicts a form of thermally conductive and damping apparatus for electronic devices in accordance with an exemplary embodiment disclosed herein;
FIG. 3 depicts an alternative form of the thermally conductive and damping apparatus for electronic devices of FIG. 2;
FIG. 4 depicts a alternative form of the thermally conductive and damping apparatus for electronic devices of FIG. 2; and
FIG. 5 depicts an alternative form of the thermally conductive and damping apparatus for electronic devices of FIG. 2.

### DETAILED DESCRIPTION

Specific embodiments of the present disclosure will now be described in detail with reference to the accompanying drawings. Further, in the following detailed description of embodiments of the present disclosure, numerous specific details are set forth in order to provide a more thorough understanding of the invention. However, it will be apparent to one of ordinary skill in the art that the embodiments disclosed herein may be practiced without these specific details. In other instances, well-known features have not been described in detail to avoid unnecessarily complicating the description.

The terminology and phraseology used herein is solely used for descriptive purposes and should not be construed as limiting in scope. Language such as "including," "comprising," "having," "containing," or "involving," and variations thereof, is intended to be broad and encompass the subject matter listed thereafter, equivalents, and additional subject matter not recited.

In one aspect, embodiments disclosed herein generally relate to a providing thermal path between two or more different physical parts of a system while uncoupling mechanically those two or more parts. The apparatus may act as a thermo conductive viscoelastic suspension and in at least one embodiment is highly resistant to extreme environment such as high temperature, aggressive gas or vacuum.

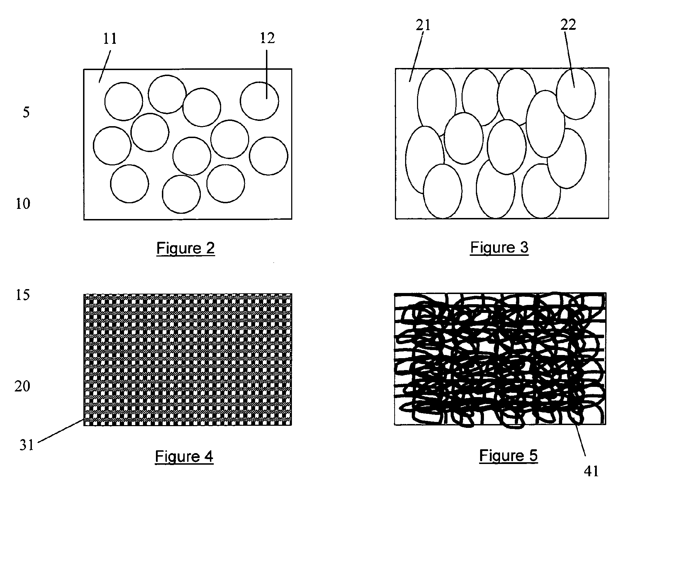

In another aspect, embodiments disclosed herein are made of a conductive elastic metallic hollow structure such as a metal mesh (see, for example, figure 5), metal foam (see, for example figures 2 or 3) or a metal fabric 31 with sufficient mechanical strength to not be degraded by the inertia of the protected electric device. This metallic matrix is similar to a spring in the apparatus. It could be made of any suitable metallic material such as steel, light alloy, copper alloy or super alloy. Some hollow structure such as metal fabric or some material internal dislocation induces friction damping which is a part of the invention.

This metallic structure may be filled with soft plastics material resistant to the environment in open matrix structure, or with any soft plastic material in closed matrix such as metallic foam. This plastic filler is similar to a viscoelastic and a friction damper. This material could be thermally conductive or not, but thermally conductive material helps the general thermally efficiency of the apparatus. It could be made of elastomer such silicone, butyl, etc or soft metal such lead alloy, indium alloy, etc.

The technologies to build the different type of metallic hollow structure are now well known for each solutions (metal mesh, open or closed foam, etc.).

The apparatus according to an embodiment of the disclosure is then bonded by any mean to both parts of the system; the electronic device which must be cooled and the mechanical structure which is the cooling source.

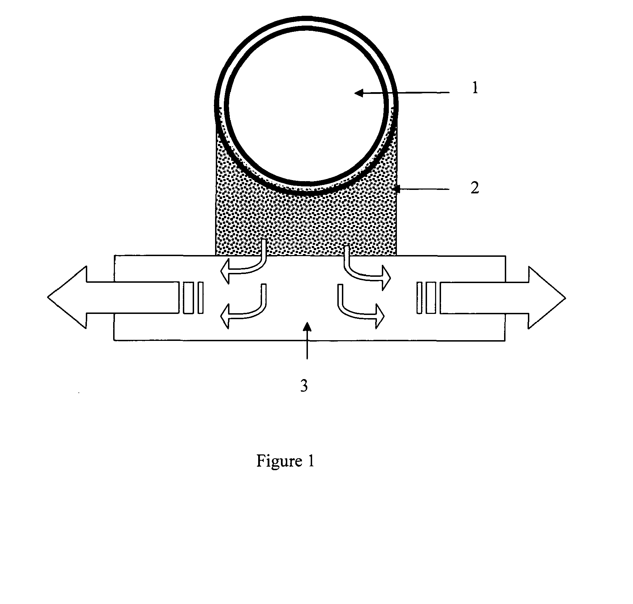

Referring to the drawings, illustrations, pictures and attachments and in particular FIG. 1, an exemplary thermally conductive and damping apparatus for electronic device for use according to the present disclosure is depicted. The figure shows the device, in some examples an electronic device 1 which creates or provides heat, this device 1 is protected from heat damage by forms of the disclosure. Also shown is the thermally conductive and damping apparatus according to forms of the disclosure 2, a number of alternative forms of which are herein described. Also shown in one form of the present disclosure is a support device, in some alternatives a chassis 3 which provides support to the device 1 and a sink for heat transferred therefrom.

As noted above, prior art solutions are limited in terms of environment life time survival because they are mechanically weakened and degraded by high temperature and chemical combination with gas and other molecules.

In the context of the present disclosure, the thermo conductive material can include any thermo conductive known in the art (suitable for use in the environments likely to be encountered), such as metal mesh (see for example figure 5), metal foam (see for example figure 2 or 3) or a metal fabric (see for example figure 4). One skilled in the art will recognize that alternative thermo conductive material can be employed in practicing the present disclosure, including but not limited to other types of means that convey thermal energy, such as alloys.

Referring now to FIGS. 2, 3, 4 and 5 alternative implementations of the present disclosure are depicted to be in which alternative forms of the system providing thermal path between two or more different physical parts of a system while uncoupling mechanically are depicted. Figure 2 shows a metal or metallic foam including a hollow metallic matrix 11 with soft plastic filler 12, is this embodiment the form is of a closed cell variety. In an alternative embodiment shown in figure 3 the metal or metallic foam includes a hollow metallic matrix 21 with soft plastic filler 22 which takes the form of an open cell foam.

Figure 4 shows the metallic material 31 taking the form of a fabric and figure 5 shows the metallic material 41 taking the form of a mesh.

Although the present disclosure has been described with reference to exemplary embodiments and implementations thereof, the present disclosure is not to be limited by or to such exemplary embodiments and/or implementations. Rather, the systems and methods of the present disclosure are susceptible to various modifications, variations and/or enhancements without departing from the spirit or scope of the present disclosure. Accordingly, the present disclosure expressly encompasses all such modifications, variations and enhancements within its scope.

## Claims

1. An apparatus for the thermally conductive and damping apparatus for electronics as described herein and above.

2. A system for thermally conductive and damping apparatus for electronic as described above and herein.

3. A method for thermally conductive and damping apparatus for electronic as described above and herein.
